# EUROPEAN PATENT SPECIFICATION

(11) **EP 3 340 287 B1**
(45) Date of publication and mention of the grant of the patent: **28.10.2020**
(21) Application number: 16206868.8
(22) Date of filing: 23.12.2016
(51) Int. Cl.: G01K 5/56, H01L 23/00, H01L 21/66, H01L 21/67

(54) **PATTERN-BASED TEMPERATURE MEASUREMENT FOR A BONDING DEVICE AND A BONDING SYSTEM**
MUSTERBASIERTE TEMPERATURMESSUNG FÜR EINE VERBINDUNGSVORRICHTUNG UND EIN VERBINDUNGSSYSTEM
MESURE DE TEMPÉRATURE BASÉE SUR UN MOTIF POUR UN DISPOSITIF DE COLLAGE ET UN SYSTÈME DE COLLAGE

(43) Date of publication of application: 27.06.2018
(73) Proprietor: Huawei Technologies Co., Ltd., Longgang District Shenzhen, Guangdong 518129 (CN)
(72) Inventor: YOUSEFI, Mirvais, 80992 Munich (DE); NAEEM, Muhammad, 80992 Munich (DE)
(74) Representative: Roth, Sebastian

(56) References cited:
- DE-A1- 4 000 945
- JP-A- 2003 156 370
- US-A- 5 272 310
- US-A1- 2004 047 398
- US-A1- 2009 117 347
- US-A1- 2014 130 730
- US-A1- 2015 249 027
- US-A1- 2016 052 830
- US-B1- 6 962 437
- US-B1- 9 466 538

## Description

### FIELD OF THE INVENTION

The present invention relates to the field of bonding devices and bonding systems, and to pattern-based temperature measurement.

### BACKGROUND

In a process of bonding semiconductor devices to a substrate (e.g. by means of laser-assisted soldering technology) a temperature of the surface of the substrate, before the semiconductor device is placed on the surface, is of particular importance. The temperature of the surface of the substrate before placing the semiconductor device on the surface of the substrate influences both quality, and a throughput rate of the bonding process.

In conventional bonding devices and bonding systems, temperature measurement is commonly implemented by means of a pyrometer. The pyrometer is arranged at a distance from the surface of the substrate, and measures infrared radiation which is emitted by the surface of the substrate. The emitted infrared radiation is dependent on a temperature of the surface of the substrate. The pyrometer detects emitted infrared radiation and uses a calibration table to convert values of the emitted infrared radiation to a temperature.

However, measuring the temperature of the surface of the substrate with a pyrometer involves several disadvantages.

Temperature measurement by means of a pyrometer is a way of indirect temperature measurement. That is, the pyrometer is arranged at a distance to the surface of the substrate of which a temperature is to be measured. An increasing distance between the pyrometer and the samples leads to a higher amount of noise which is detected by the pyrometer, and results in a lower resolution of the pyrometer and lower accuracy of the temperature measurement. Temperature measurement by means of a pyrometer is also dependent on the type, or material of the substrate which is to be measured. As the pyrometer typically exploits an effect of black-body radiation to determine the temperature of the substrate, and a black-body radiation of the substrate changes according to a specific material or type of the substrate, a calibration of the pyrometer according to a substrate type or material which is to be measured, often is necessary in order to ensure accuracy of temperature measurement. Another drawback of the indirect way of temperature measurement is that heat sources which are located in the vicinity of the substrate which is to be measured also generate infrared radiation which can interfere with the infrared radiation which is emitted by the substrate and can cause a loss of accuracy of the temperature measurement. An undesired heat source in the vicinity of the substrate can be, for example, a part of the bonding device or the bonding system itself, for example a bonding tool which is comprised by the bonding device.

In addition, dimensions of the pyrometer can be large, and the pyrometer may not be located in a motion range of the bonding device, or within a housing of the bonding system. Thus, the distance between the pyrometer and the substrate increases, which leads to a decreasing accuracy of temperature measurement.

As a result, in the field of conventional bonding devices and conventional bonding systems, the problem exists that there is no way of measuring the temperature of a substrate in a bonding process, which provides a desired amount of accuracy, a low number of processing steps (which can't be reached by conventional solutions due to the necessity of calibrating the pyrometer), and which complies with design requirements of the bonding device or the bonding system.

US 5 272 310 A discloses a method of soldering electronic components to each other.

US 6 962 437 B1 discloses a method and apparatus for thermal profiling of flip-chip packages.

JP 2003 156370 A discloses a bonding apparatus and an image sensor taking an image of a regular geometrical pattern which is disposed on the case of a temperature sensor and which is deformable by temperature.

### SUMMARY

In view of the above-mentioned problems of the conventional solutions, the present invention aims to improve the state of the art.

The present invention particularly has the object to provide a bonding device, a system and method in which accuracy of temperature measurement during a bonding process is increased.

The above-mentioned object of the present invention is achieved by the solution provided in the enclosed independent claims. Advantageous implementations of the present invention are further defined in the respective dependent claims.

A first aspect of the present invention provides a bonding device for bonding semiconductor devices to a substrate, the bonding device comprising a temperature probe comprising a first surface, wherein the first surface is configured to contact a surface of the substrate to measure a temperature of the surface of the substrate, and the first surface comprises a pattern configured to change its shape according to the temperature of the surface of the substrate, wherein dimensions of the first surface are larger than dimensions of a predefined part of the surface of the substrate, wherein the first surface is configured to directly contact the predefined part of the surface of the substrate to measure a temperature of the predefined part of the surface of the substrate, wherein the predefined part is a part of the surface of the substrate, which is heated by a heating source, wherein the pattern comprised by the first surface is a regular geometrical pattern.

In the bonding device according to the first aspect, accuracy of temperature measurement is increased by implementing a direct (i.e. a contact-based) way of temperature measurement that uses a temperature probe which comprises a first surface to measure a temperature of a surface of a substrate. As the first surface of the temperature probe is configured to contact the surface of the substrate in order to measure the temperature of the surface of the substrate, a direct way of temperature measurement can be implemented which does not require a calibration in order to measure a temperature of substrates of different type or different material. Production steps and production costs of a bonding process thus can be considerably decreased, since no calibration of the temperature probe is necessary. In order to determine a temperature of the first surface of the temperature probe, the first surface comprises a pattern which is configured to change its shape according to a temperature to which the first surface comprising the pattern is exposed. Thus, the temperature of the surface of the substrate can be determined by contacting the surface of the substrate with the first surface comprising the pattern. A temperature-based change of the shape of the pattern can be determined, e.g. by an external image capturing device, and can be converted to a temperature value by an external control unit, e.g. by means of comparing a captured shape of the changed pattern with a reference shape of the pattern. As the temperature probe comprising the first surface with the pattern is directly comprised by the bonding device, the temperature probe does not restrain the motion range of the bonding device. Due to the small dimensions which are required by the temperature probe comprising the first surface with the pattern, design requirements of the bonding device, which e.g. can be arranged within the housing of a bonding system which provides limited space, can be complied with.

Providing the first surface with larger dimensions than dimensions of the predefined part of the surface of the substrate (i.e. the part of the surface of the substrate of which the temperature is to be measured by means of the first surface) ensures that an analysis of the pattern of the first surface is more accurate, which increases accuracy of temperature measurement. In case that the pattern is a checkered pattern, it is beneficial if the checkered pattern projects the predefined part of the surface of the substrate by a width of two checkered columns at each edge of the predefined part of the surface of the substrate. The predefined part is the part of the surface of the substrate, which is heated by a heating source, such as a laser, to allow bonding of a component on the substrate.

Shaping the pattern as a regular geometrical pattern, e.g. a checkered pattern, ensures that the pattern can be easily and effectively analyzed, for example by analyzing a Fourier transformation of the pattern.

According to a first implementation of the first aspect, the pattern can be formed in and/or on the first surface by edging technology and/or anodization technology.

This ensures that the pattern can be formed firmly in the first surface by being edged into the first surface, or that the pattern can be firmly formed on the first surface by being anodized onto the first surface.

According to a second implementation of the first aspect, the temperature probe can comprise a main body on which the first surface is arranged.

This ensures that the first surface can be formed as a thin plane, while the shape of the main body can be used to arrange the first surface in a predefined position.

According to a third implementation of the first aspect, the main body and the first surface can be formed of different materials.

This ensures that predefined material properties of the main body, as well as of the first surface can be exploited in order to achieve a desired characteristic of the main body as well as of the first surface, when the main body and the first surface are exposed to a heat source.

According to a fourth implementation of the first aspect, a thermal expansion coefficient of the material that is used to form the main body can be smaller than a thermal expansion coefficient of the material of which the first surface is formed.

Providing the main body with a smaller thermal expansion coefficient than the first surface (i.e. the main body deforms less, compared to the first surface, when being exposed to a change of temperature) ensures that the main body can be used to arrange the first surface at a predefined position (which requires large dimensions of the main body), while the first surface is formed as a thin plane, which prevents the temperature probe from extending into the direction of the surface of the substrate, when the temperature probe (which includes the main body and the first surface) is exposed to a change of temperature. As a result, damage of the substrate due to expansion of the overall temperature probe can be prevented. Only the shape of the very thin first surface including the pattern changes, when the temperature probe is exposed to a change of temperature. The main body maintains its shape, due to the small thermal expansion coefficient of the material that is used to form the main body.

With the expression "exposed to a change of temperature" it is meant in this document that an object, in particular the first surface, is exposed to a heat change, thereby undergoing a change of temperature.

According to a fifth implementation of the first aspect, the bonding device further can comprise a bonding tool and a single axis actuator. The temperature probe can be arranged at the single axis actuator of the bonding device, and the single axis actuator can be configured to, in a temperature measuring state, press the temperature probe towards the surface of the substrate, such that the first surface contacts the surface of the substrate.

Supplying the bonding device (which e.g. can be a movable head which can be moved within the housing of a bonding system in e.g. three dimensions) with a bonding tool (which e.g. can be a vacuum gripper or a heating tip), ensures that the bonding device can perform bonding of a semiconductor device to a substrate during a bonding process. Arranging the temperature probe at the single axis actuator of the bonding device allows for varying the position of the temperature probe. The position of the temperature probe can in particular be adjusted in relation to the bonding tool. The single axis actuator in particular ensures that, in a temperature measuring state, the temperature probe can be pressed towards the surface of the substrate, such that the first surface contacts the surface of the substrate. The single axis actuator in particular facilitates that in the temperature measuring state, the temperature probe projects further away from the bonding device than the bonding tool. Thus, a semiconductor device can be held by the bonding tool, while the temperature probe is pressed against the surface of the substrate by the single axis actuator without causing damage to the semiconductor device held by the bonding tool, or to the surface of the substrate, e.g. due to a direct contact of the semiconductor device and the surface of the substrate.

According to a second aspect, the present invention provides a bonding system for bonding semiconductor devices to a substrate, the bonding system comprising the bonding device according to the first aspect or anyone of its implementations, an image capturing device and a control unit, wherein the control unit is configured to control the image capturing device to capture a current shape of the pattern, determine a temperature profile by evaluating the captured shape of the pattern, and control the bonding system according to the temperature profile.

This ensures, that a bonding system, which is equipped with the bonding device according to the first aspect or anyone of its implementations, can determine the temperature of a surface of a substrate during a bonding process by capturing a current shape of the pattern of the first surface of the bonding device and comparing the captured shape to a reference shape. The temperature of a surface of a substrate can in particular be represented by a temperature profile, i.e. a two-dimensional representation of temperatures of the measured surface of the substrate. The bonding system can in turn be controlled by the control unit according to the determined temperature or the determined temperature profile.

The bonding device which is comprised by the bonding system according to the second aspect comprises all benefits and advantages of the bonding device according to the first aspect or anyone of its implementations.

According to a first implementation of the second aspect, the control unit can further be configured to convert the captured shape of the pattern into a spatial deformation profile of the first surface by projecting the captured shape of the pattern on a complete mathematical set of functions.

In other words, projecting the captured shape of the pattern on a complete mathematical set of functions means that the captured shape of the pattern can successfully be subject to a Fourier transformation. Thus, the above implementation ensures that the captured shape of the pattern can be converted into a spatial deformation profile of the first surface by means of a Fourier transformation of the captured shape of the pattern.

According to a second implementation of the second aspect, the control unit can further be configured to obtain the temperature profile from the spatial deformation profile, based on coefficients of the complete mathematical set of functions and a thermal expansion coefficient of the material of which the first surface is formed.

In other words, this ensures that the temperature profile can be obtained from the spatial deformation profile based on Fourier coefficients of the captured shape of the pattern and a thermal expansion coefficient of the first surface.

According to a third aspect, the present invention provides a method for operating the bonding system according to the second aspect or anyone of its implementations, wherein the method comprises, controlling, by the control unit, the image capturing device to capture a current shape of the pattern, determining, by the control unit, a temperature profile by evaluating the captured shape of the pattern, and controlling, by the control unit, the bonding system according to the temperature profile.

According to a first implementation of the third aspect, the method further can comprise the step of converting, by the control unit, the captured shape of the pattern to a spatial deformation profile of the first surface by projecting the shape of the captured pattern on a complete mathematical set of functions.

According to a second implementation of the third aspect, the method further can comprise the step of obtaining, by the control unit, the temperature profile from the spatial deformation profile based on coefficients of the complete mathematical set of functions and a thermal expansion coefficient of the material of which the first surface is formed.

The advantages and benefits of the third aspect and its implementations include all advantages and benefits of the second aspect or anyone of its implementations.

Generally, it has to be noted that all arrangements, devices, modules, components, models, elements, units and means and so forth described in the present application could be implemented by software or hardware elements or any kind of combination thereof. All steps which are performed by the various entities described in the present application as well as the functionality described to be performed by the various entities are intended to means that the respective entity is adapted to, or is configured to perform the respective steps and functionalities.

Even if the following description of the specific embodiments, a specific functionality or step to be performed by a general entity is not reflected in the description of a specific detailed element of the entity which performs the specific step or functionality, it should be clear for a skilled person that these methods and functionalities can be implemented in respective hardware or software elements or any kind of combination thereof. Further, the method of the present invention and its various steps are embodied in the functionalities of the various described apparatus elements.

### BRIEF DESCRIPTION OF THE DRAWINGS

The above-described aspects and embodiments of the present invention will now also be discussed with reference to the figures:
- FIG. 1: shows a schematic illustration of a bonding device according to an embodiment of the present invention.
- FIG. 2: shows a schematic illustration of a principle of determining a temperature profile by evaluating a captured shape of a pattern.
- FIG. 3: shows an example of a pattern and its Fourier transformation.
- FIG. 4: shows a schematic overview of a bonding device according to an embodiment of the present invention in more detail.
- FIG. 5: shows a possible implementation manner of a bonding device.
- FIG. 6: shows a schematic overview of a bonding system according to an embodiment of the present invention.
- FIG. 7: shows a schematic illustration of an operating example of a bonding system.
- FIG. 8: shows a flow diagram of a method for operating the bonding system according to an embodiment of the present invention.

### DETAILED DESCRIPTION OF THE EMBODIMENTS

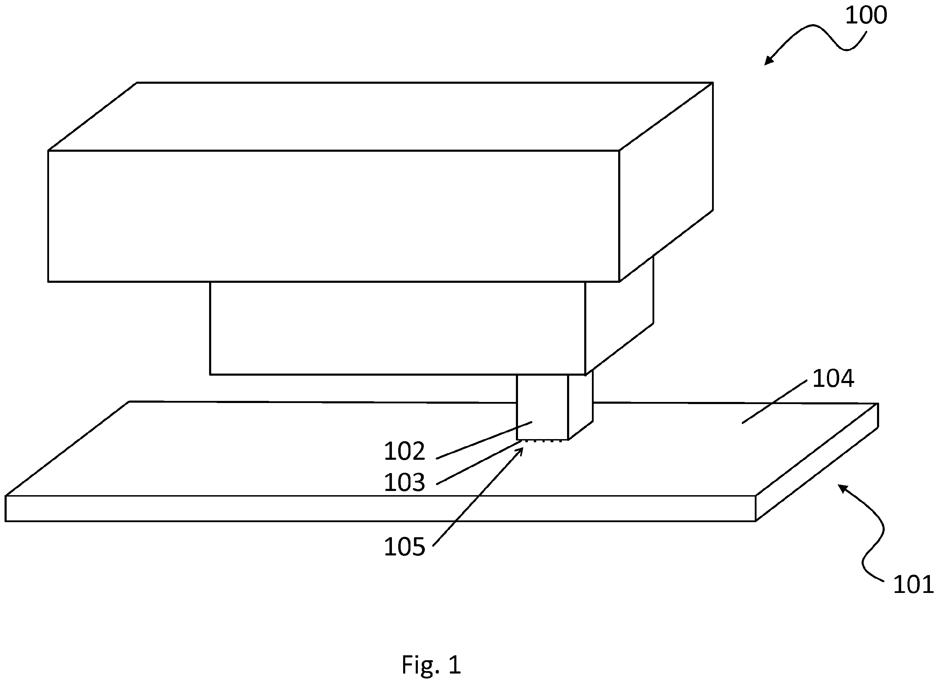

FIG. 1 shows a schematic illustration of a bonding device 100 according to an embodiment of the present invention. The bonding device 100 is in particular suitable for bonding semiconductor devices (such as a die) to a substrate 101. The bonding device 100 can in particular be implemented as a movable mounting head, which is movable in at least one dimension, preferably in three dimensions, and can be equipped with a bonding tool such as a heating tip or a vacuum gripper. The bonding device 100 can in particular be comprised by a bonding system, and can be moved in the bonding system by means of e.g. at least one axial actuator, or robotic technology. The bonding device 100 and the bonding system can in particular be products manufactured by the manufacturer AMICRA microtechnologies.

As it is shown in FIG.1, the bonding device 100 comprises a temperature probe 102, wherein the temperature probe 102 comprises a first surface 103. The first surface 103 is configured to contact a surface 104 of the substrate 101. In a temperature measuring state, this allows for planary resting of the first surface 103 on the surface 104 of the substrate 101, which provides a contact-based way to measure a temperature of the surface 104 of the substrate 101 by means of the first surface 103.

The first surface 103 comprises a pattern 105. The first surface 103 with the pattern 105 is configured to change its shape (the shape of the first surface 103 which also results in a change of a shape of the pattern 105) according to the measured temperature of the surface 104 of the substrate 101.

Temperature measurement by means of the temperature probe 102 comprising the first surface 103 with the pattern 105 can be performed at any temperature of the substrate 101, preferably within a temperature range of 200 to 400 degrees centigrade, which is a typical temperature range in which solder (that is used for the bonding process) melts. The temperature probe 102 comprising the first surface 103 with the pattern 105 allows for temperature measurement at a resolution of smaller than 1 K, specifically at a resolution of 0,5 K, more specifically at a resolution of 0,1 K.

The first surface 103 comprising the pattern 105 is preferably formed of Nitinol, which has a thermal expansion coefficient of 6.6x10^-6/K or 11x10^-6/K (martensite or austenite, respectively). Alternatively, the first surface 103 comprising the pattern 105 can also be formed of zinc copper (thermal expansion coefficient: 33-35x10^-6/K), cast magnesium aluminum manganese (thermal expansion coefficient: 25-26x10^-6/K), zinc aluminum (thermal expansion coefficient : 22-28x10^-6/K), cast magnesium aluminum zinc (25-26x10^-6/K) or any other metallic alloy with a thermal expansion coefficient greater than 25x10^-6/K.

In order to allow for a uniform deformation of the first surface 103 with the pattern 105, when the first surface 103 with the pattern 105 is exposed to a change of temperature, a thickness of the first surface 103 preferably ranges from 1 mm to 10 mm, more preferably from 1 mm to 5 mm, such that an expansion of the first surface 103 (in a direction perpendicular to the surface 104) is negligible.

The pattern 105 comprised by the first surface 103 is a regular geometrical pattern. The regular geometrical pattern can in particular be regarded as a visual structure, which is organized in a consistent, regular manner. This allows for effectively and efficiently evaluating a change of the shape of the pattern 105, e.g. by performing a Fourier transformation of a captured shape of the pattern 105. A regular pattern can e.g. be a checkered pattern, or a regular arrangement of circles or lines.

Optionally, the pattern 105 can be formed in the first surface 103 by edging technology. Alternatively or additionally, the pattern 105 can be formed on the first surface 103 by anodization technology. Edging technology changes the first surface 103 in that parts of the first surface 103 are abraded, and in that the pattern 105 is thereby visualized as a darker shading in and/or on the first surface 103. Anodization technology changes the first surface 103 in that material of a different color can be anodized to the first surface 103, thereby visualizing the pattern 105 in the color of the material which is anodized to the first surface 103. This ensures that the pattern 105 can be firmly formed in and/or on the first surface 103.

When the first surface 103 heats up locally, the first surface 103 expands and the pattern 105 comprised by the first surface 103 deforms. The amount of deformation is proportional to a temperature to which the first surface 103 with the pattern 105 is exposed. In an exemplary implementation, in which Nitinol is used as a material to form the first surface 103, an effect of deformation can be quite large, which leads to a noticeable change of the shape of the pattern 105, e.g. when comparing a captured reference shape of the pattern 105 (which was captured before the first surface 103 with the pattern 105 was exposed to a change of temperature with a captured shape of the pattern 105, after the first surface 103 with the pattern 105 was exposed to a change of temperature.

The change of the shape of the pattern 105 is in particular dependent on the expansion coefficient of the material of which the first surface 103 with the pattern 105 is formed. Using Nitinol to form the first surface 103 with the pattern 105 is in particular beneficial, since Nitinol has a large thermal expansion coefficient and deforms in a large ratio compared to the amount of change of temperature to which it is exposed. Nitinol is further beneficial, since it remembers its original shape, and after a deformation due to thermal influences, returns to its pre-deformed shape again, when it goes back to the former temperature.

By capturing a current shape of the pattern 105, and by taking into account the thermal expansion coefficients of the material of which the first surface 103 with the pattern 105 is formed, it is possible to calculate a temperature profile that caused a deformation of the pattern 105.

The temperature profile can be a two-dimensional representation of temperatures of the measured surface 104 of the substrate 101. Obtaining a temperature profile of the surface 104 of the substrate 101 can also be referred to as measuring a temperature of the surface 104 of the substrate 101.

Capturing of the pattern 105 of the first surface 103 can in particular be implemented by an image capturing device, which is typically present in a bonding system that can comprise a bonding device 100.

The calculated temperature profile of the surface 104 of the substrate 101 can in particular be used to control a laser, which is also typically comprised by the bonding system, and is configured to heat the substrate 101 at an opposite side of the side at which the temperature of the surface 104 of the substrate 101 is measured. More specifically, a feedback loop can be implemented in the bonding system, according to which the laser can be controlled to heat the opposite side of the substrate 101 according to the temperature which was measured on the surface 104 of the substrate 101.

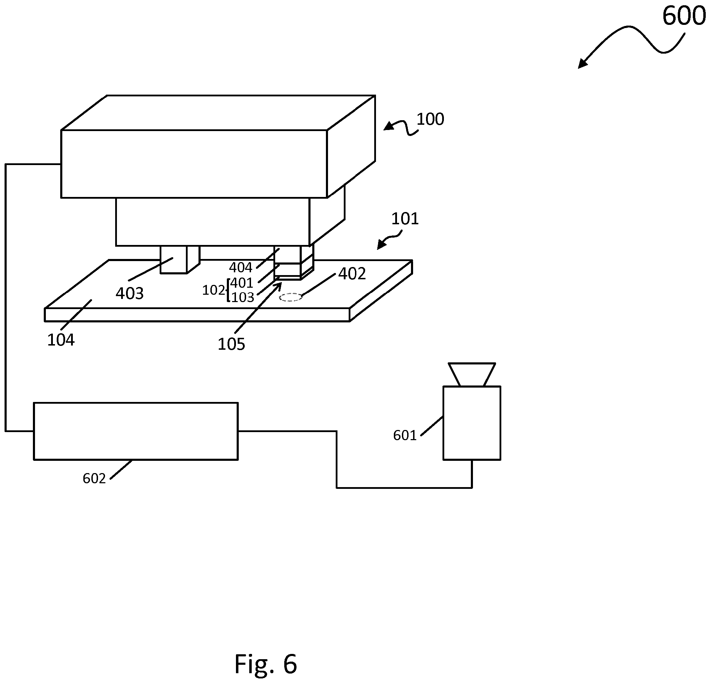

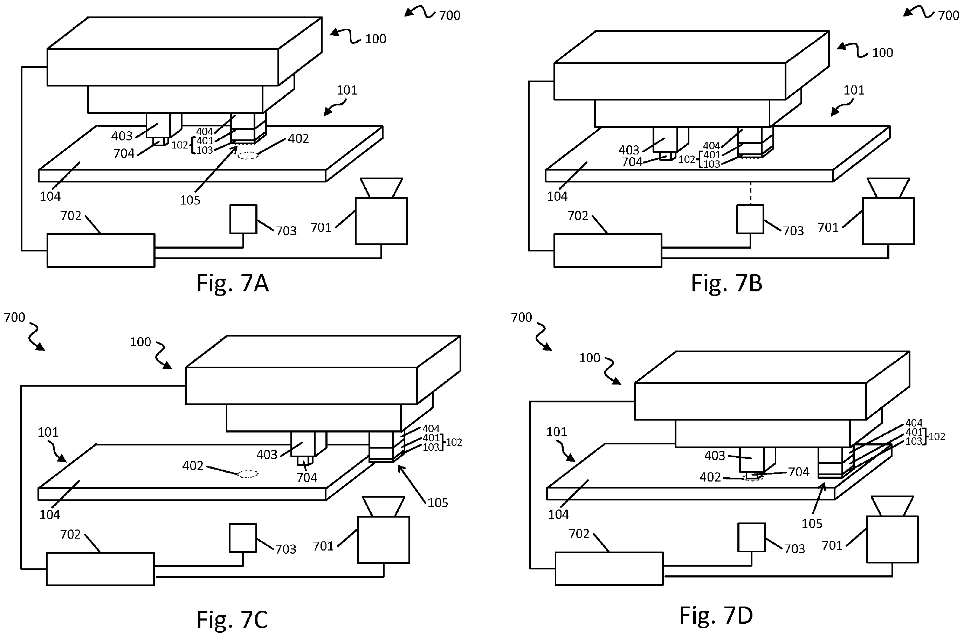

An implementation example of the bonding system comprising the bonding device 100, an image capturing device, and a control unit is going to be described in more detail in view of FIG. 6 below. An implementation example of the bonding system comprising the bonding device 100, an image capturing device, a control unit, and a laser is going to be described in more detail in view of FIG. 7 below.

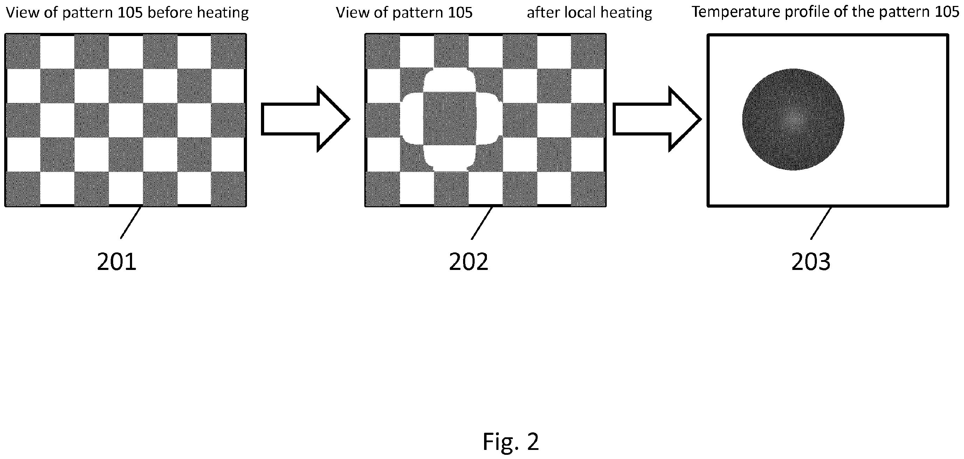

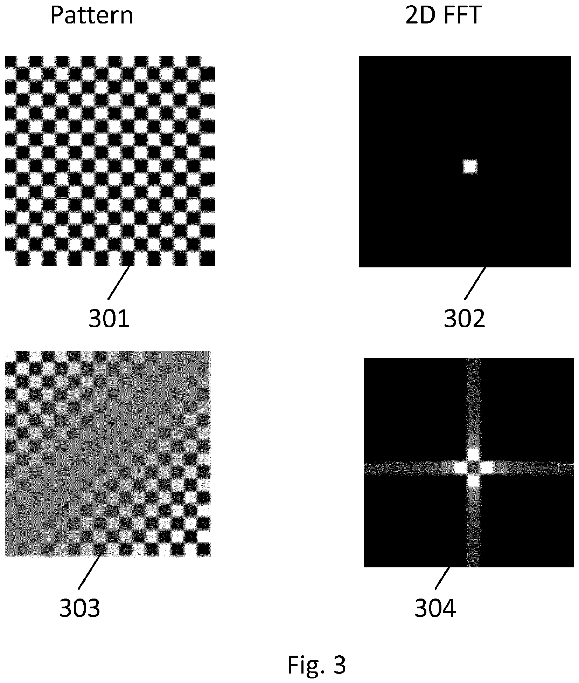

It is now going to be described in view of FIG. 2 and FIG. 3, how a change of the shape of the pattern 105, which is comprised by the first surface 103, can be evaluated in order to determine a temperature profile of the surface 104 of the substrate 101.

FIG. 2 shows a schematic illustration of a principle of determining a temperature profile by evaluating a captured shape of a pattern.

More specifically, FIG. 2 shows a schematic view 201 of a shape of a reference pattern, which did not undergo a change of temperature. The reference pattern e.g. can be the pattern 105, before the pattern 105 was locally exposed to a heat source, e.g. by directly contacting a heated area of the surface 104 of the substrate 101, thereby causing a change of temperature of the first surface 103 and/or the pattern 105. After contacting the surface 104 of the substrate 101, and thereby being exposed to the heat of the surface 104 of the substrate 101, the first surface 103 with the pattern 105 deforms according to the temperature of the surface 104 of the substrate 101.

In FIG. 2, this is illustrated by a schematic view of a current pattern 202 resulting from the exposure of the reference pattern 201 to a heat source. The current pattern 202 can e.g. be the pattern 105 after it was locally exposed to a heat source. In the schematic view 202 it can in particular be seen that the part of the pattern 105 which e.g. contacted a heated area of the surface 104 of the substrate 101, expanded. This is in particular illustrated by the curved edges of some of the squares of which the checkered pattern is composed. In other words, the first surface 103 with the pattern 105 deforms as a function of localized temperature change due to contacting the heated surface 104 of the substrate 101 by the first surface 103 with the pattern 105.

As a result, a temperature profile 203 can be calculated e.g. based on a Fourier transformation of a captured shape (e.g. the schematic view 202) of the pattern 105 and on material properties of the first surface 103 with the pattern 105 (e.g. a thermal expansion coefficient of the material of which the first surface 103 is formed).

In view of FIG. 3, it is described how a captured shape of a pattern is processed in a Fourier transformation. FIG. 3 shows examples of patterns and their Fourier transformations. More specifically, FIG. 3 shows a schematic illustration of a checkered pattern 301 and a schematic illustration of a Fourier transformation 302 of the checkered pattern 301 (e.g. a 2D Fast Fourier Transformation). The checkered pattern 301 can be in particular the pattern 105 of the first surface 103 (before it was exposed to a heat source). Implementing the pattern 105 of the first surface 103 as a checkered pattern 301 as shown in FIG. 3 is beneficial due to the ease of using a Fourier transformation to evaluate a change of the checkered pattern 301.

Generally, the Fourier transformation of a uniform two-dimensional checkered pattern is a single point in a two-dimensional space (e.g. the Fourier Transformation 302) which identifies two frequencies of the checkered pattern 301 (one frequency regarding an x-direction and one frequency regarding a y-direction). A change of the shape of the checkered pattern 301 (as illustrated in a deformed pattern 303) will cause the frequencies which appear in the Fourier transformation, to change (as illustrated in a Fourier transformation 304 of the deformed pattern). In the specific example as shown in view of FIG. 3, a change of the shape of the checkered pattern 301 is going to result in further frequencies or frequency bands appearing in the Fourier transformation 304. In the specific example as shown in FIG. 3, this results in further white or grey rectangles appearing in the schematic illustration of the Fourier transformation 304.

A deformation of the first surface 103 is directly proportional to the amount of heat deposited on the first surface 103, e.g. a temperature change of the first surface 103 relative to a "cool", or default state of the first surface 103.

As the checkered pattern 301 deforms, a Fourier spectrum changes and becomes fuller (e.g. more frequency components appear). In order to obtain a temperature profile of the deformed pattern 303, firstly the Fourier transforms of the checkered pattern 301 and the deformed pattern 303 are determined. Secondly, the Fourier transform 302 of the checkered pattern 301 is subtracted from the Fourier transform 304 of the deformed pattern 303 and inverse transformed. This inversed transformed pattern is the deformation of the surface.

In practice, a model would be built, relating Fourier spectra to an expansion profile and the inverse transform would not be required. This would require some basic calibration of the tooling.

More specifically, any pattern that can be projected on a complete mathematical set can be used. In other words, this means that any pattern which can be successfully processed in a Fourier transformation can be used.

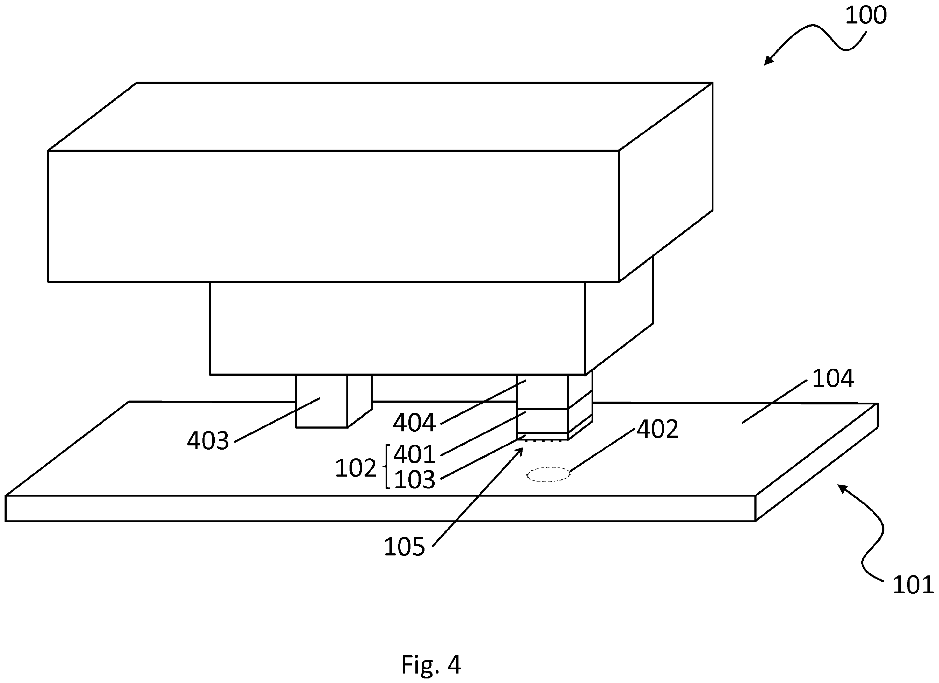

Optional features of the bonding device 100 are now described in view of FIG. 4 below.

FIG. 4 shows a schematic overview of a bonding device 100 according to an embodiment of the present invention in more detail. As it is illustrated in FIG. 4, the temperature probe 102 of the bonding device 100 can further comprise an optional main body 401. The first surface 103 can be arranged on the main body 401 in order to distance the first surface 103 from the remaining elements and parts of the bonding device 100. The shape of the main body 401 can in particular be configured to arrange the first surface 103 in a predefined position, which is best suited for temperature measurement of the surface 104 of the substrate 101. This in particular ensures that the remaining parts and elements of the bonding device 100 do not touch or damage the substrate 101, when the first surface 103 contacts the surface 104 of the substrate 101 in order to measure a temperature of the surface 104 of the substrate 101.

Dimensions of a base area of the main body 401 can be the same as dimensions of the first surface 103. A height of the main body 401 can be adapted to position the first surface 103 in a predefined position. The height of the main body 401 can for example range from 1 mm to 20 mm.

Further optionally, the main body 401 can be used to avoid an undue expansion of the temperature probe 102 into a longitudinal direction of the temperature probe 102, when the temperature probe 102 undergoes a change of temperature. To this end, the main body 401 and the first surface 103 can be formed of different materials. For example, silicon carbide (which has a thermal expansion coefficient of 4x10^-6/K) can be used to form the main body 401, while Nitinol (which has a considerably larger thermal expansion coefficient) can be used to form the first surface 103. More specifically, any material which has a thermal expansion coefficient smaller than 5x10^-6/K can be used to form the main body 401.

Forming the main body 401 and the first surface 103 of different materials ensures that the shape of the pattern 105 of the very thin first surface 103 (which e.g. can have a height of only a few mm) can deform under thermal influence, while the main body 401 maintains its original shape. Thereby, an expansion of the overall temperature probe 102 into the longitudinal extension of the temperature probe 102 is prevented, which may damage the substrate 101 when the temperature probe 102 is pressed onto the substrate 101, e.g. in a temperature measuring state of the bonding device 100.

As a result, it is not only beneficial if the main body 401 and the first surface 103 are formed of different materials, but also if, further optionally, a thermal expansion coefficient of the main body 401 is smaller than a thermal expansion coefficient of the first surface 103. More specifically, it is beneficial, if the thermal expansion coefficient of the main body 401 is smaller than 5x10^-6/K, and if the thermal expansion coefficient of the first surface 103 is greater than 10x10^-6/K.

In order to allow for accurately measuring the temperature of the surface 104 of the substrate 101 by means of the temperature probe 102, optionally, dimensions of the first surface 103 can be larger than dimensions of a predefined part 402 of the surface 104 of the substrate 101, wherein the first surface 103 is configured to directly contact the predefined part 402 of the surface 104 of the substrate 101 to measure a temperature of the predefined part 402 of the surface 104 of the substrate 101. The predefined part 402 is the part of the surface of the substrate, which is heated by a heating source, such as a laser, to allow bonding of a component on the substrate. To allow for accurately measuring a temperature by evaluating a change of the shape of the pattern 105, the dimensions of the first surface 103 can be, for instance, at least be 20% larger than the dimensions of the predefined part 402 of the surface 104, or alternatively, if a checkered pattern is used, the dimensions of the first surface 103 should extend by at least two checkered columns at every edge of the first surface 103 over the dimensions of the predefined part 402 of the surface 104. The larger dimensions of the first surface 103 compared to the dimensions of the predefined part 402 of the surface 104 of the substrate 101 allow for a normalization of the measurement data which is generated by evaluating a captured shape of the pattern 105 of the first surface 103, which leads to more accurate measurement results.

As it is illustrated in FIG. 4, the bonding device 100 further can comprise an optional bonding tool 403. The bonding tool 403 can for example be a vacuum gripper, or a heating tip, which can be used to place a semiconductor device on the surface 104 of the substrate 101 and to bond the semiconductor device to the surface 104 of the substrate 101 after the temperature of the position at which the die is placed, i.e. the predefined part 402, was measured by means of the temperature probe 102 in a previous operating step.

More specifically, the bonding tool 403 can be arranged at a same side of the bonding device 100 as the temperature probe 102.

In order to minimize movement of the bonding device 100 in a bonding process, which is necessary to measure a temperature of the surface 104 of the substrate 101 before bonding a semiconductor device to the substrate 101, the temperature probe 102 and the bonding tool 403 optionally can extend into a basically similar direction (i.e. both, the temperature probe 102 and the bonding tool 403 are pointing towards the surface 104 of the substrate 101 during a bonding process).

FIG. 4 additionally shows an optional single axis actuator 404 at which the temperature probe 102 is arranged. More specifically, the single axis actuator 404 is configured to arrange the temperature probe 102 at the remaining parts and elements of the bonding device 100, and to simultaneously allow for a linear movement of the temperature probe 102 in relation to the remaining parts of the bonding device 100. This ensures that the single axis actuator 404 can press, in a temperature measuring state, the temperature probe 102 towards the surface 104 of the substrate 101. Thus, the first surface 103 contacts the surface 104 of the substrate 101, and a temperature of the surface 104 of the substrate 101 can be measured by the first surface 103. More specifically, in order to transfer the temperature probe 102 into the temperature measuring state, the single axis actuator 404 can be configured to perform the linear movement of the temperature probe 102 essentially perpendicular to a plane, in which the bonding device 100 is arranged. Alternatively or additionally, the single axis actuator 404 can be configured to adjust the position of the first surface 103 of the temperature probe 102 in relation to a top surface of the bonding tool 403 (wherein the top surface of the bonding tool 403 points towards the surface 104 of the substrate 101) to allow for a measurement of a temperature of the surface 104 of the substrate 101 by the temperature probe 102, while a semiconductor device is arranged at the top surface of the bonding tool 403. This ensures that temperature measurement can be performed by the temperature probe 102, while a semiconductor device is arranged at the bonding tool 403, without causing damage to either the semiconductor device or the substrate 101, e.g. by overdue pressing the semiconductor device onto the substrate 101 during temperature measurement.

It is to be noted that the shape of the bonding device 100 as illustrated in FIG. 1 and FIG. 4 is merely schematic, and that various shapes of the bonding device 100 can be implemented, when putting the present invention into practice.

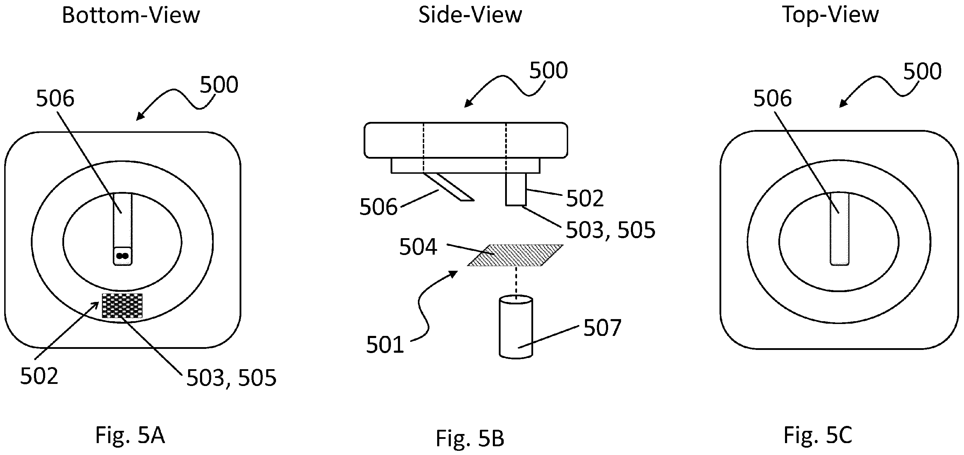

FIG. 5 shows a possible implementation manner of a bonding device 500.

More specifically, FIG. 5 shows in FIG. 5A, FIG. 5B and FIG. 5C a bottom-, side-, and top-view of the bonding device 500, which is basically identical to the bonding device 100 (i.e. the bonding device 500 comprises all features and functionality of the bonding device 100), but is implemented in an alternative structural shape.

In FIG. 5, the bonding device 500, a substrate 501, a temperature probe 502, a first surface 503, a surface 504, and a pattern 505 are shown which correspond to the respective entities of FIG. 1 and FIG. 4 which are named with similar terms and labelled with similar reference signs (i.e. they comprise the same features and functionality as the respective entities as described in view of FIG. 1 and FIG. 4). FIG. 5 additionally shows a bonding tool 506, which comprises the features and functionality of the bonding tool 403 as it was described above in view of FIG. 4. Although it is not illustrated in FIG. 4, the bonding device 500 can also comprise a main body and/or a single axis actuator, which can be configured to arrange the temperature probe 502 at the remaining parts and elements of the bonding device 500, similar to as it was described for the main body 401 and/or the single axis actuator 404 in view of FIG. 4 above.

In addition, as it is specifically illustrated in FIG. 5B, a laser 507 can be optionally arranged at an opposite side of the substrate 501, which can optionally be configured to heat the substrate 501. The laser 507 comprises the same features and functionality of the laser as it was described above and of the laser as it is going to be described in view of FIG. 7 below.

As it is indicated by the vertical dashed lines in FIG. 5B, as well as by the inner circles in FIG. 5A and FIG. 5C, the bonding device 500 comprises a through hole, through which the bonding process can be observed, e.g. by an image capturing device. Thus, the shape of the bonding device 500 is similar to the shapes of conventional bonding devices, for example, bonding devices which are manufactured by the manufacturer AMICRA microtechnologies. This ensures that bonding devices of conventional shape can be equipped with the temperature probe 502 (which includes the first surface 503 with the pattern 505), thereby improving the bonding devices of conventional shape.

FIG. 6 shows a schematic overview of a bonding system 600 according to an embodiment of the present invention. The bonding system 600 is suitable for bonding semiconductor devices (e.g. dies) to a substrate 101. The bonding system 600 comprises the bonding device 100 as it was described in view of FIG. 1, or in view of FIG. 4 above. Further, the bonding system 600 comprises an image capturing device 601 (e.g. a camera) and a control unit 602. The control unit 602 is in particular configured to control the image capturing device 601 to capture a current shape of the pattern 105, to determine a temperature profile by evaluating the captured shape of the pattern 105 and to control the bonding system 600 according to the temperature profile.

The determining of the temperature profile by evaluating the captured shape of the pattern 105 by the control unit 602 is in particular performed according to the operating principle as it was described in view of FIG. 2 and FIG. 3 above. That is, the captured current shape of the pattern 105 is processed in a Fourier transformation, and the temperature profile is generated based on coefficients of the Fourier transformation of the current shape of the pattern 105 and based on material properties of the first surface 103 with the pattern 105, in particular based on a thermal expansion coefficient of the first surface 103.

More specifically, the bonding system 600 can be configured to perform the following optional steps in order to obtain a temperature profile of the surface 104 of the substrate 101 (i.e. in order to determine a temperature of the surface 104 of the substrate 101).

Optionally, the control unit 602 of the bonding system 600 can further be configured to convert the captured shape of the pattern 105 into a spatial deformation profile of the first surface 103 by projecting the captured shape of the pattern 105 on a complete mathematical set of functions. Projecting the captured shape of the pattern 105 on a complete mathematical set of functions can also be regarded as processing the captured shape of the pattern 105 in a Fourier transformation and obtaining coefficients of the Fourier transformation. The spatial deformation profile in particular gives information about what part of the first surface 103 is deformed due to a temperature change in what spatial way and to what amount.

Optionally, the control unit 602 can further be configured to obtain the temperature profile from the spatial deformation profile based on coefficients of the complete mathematical set of functions and a thermal expansion coefficient of the first surface 103. The coefficients of the complete mathematical set of functions can be regarded as the Fourier coefficients which are obtained in the above step of processing the captured shape of the pattern 105 in a Fourier transformation.

FIG. 7 shows a schematic overview of an operating example of a bonding system 700 according to the present invention. In particular, FIG. 7 shows, in FIG. 7A, FIG. 7B, FIG. 7C and FIG. 7D, example operating steps of the bonding system 700 performed during a bonding process.

The bonding system 700 comprises the features and functionality of the bonding system 600 as it was described in view of FIG. 6 above. Therefore, the entities as shown in FIG. 7 are named with identical terms and labelled with similar reference signs, compared to the bonding system 600. The bonding system 700 additionally comprises a laser 703, which is configured to, in a heating state, heat an opposite side of the surface 104 of the substrate 101, preparatory to bonding a semiconductor device to the surface 104 of the substrate 101.

An operating example of the bonding system 700 is described in the following:
FIG. 7A shows a first step of the operating principle, in which the bonding system 700 is in an initial state. That is, a substrate 101 is loaded into the bonding system 700, a semiconductor device 704 is held by the bonding tool 403, the temperature probe 102 is in a reference state, the bonding device 100 is arranged at an initial position and the laser 703 is pointing towards a position on the substrate 101 opposite to a predefined part 402 of the surface 104 of the substrate 101 on which the semiconductor device 704 is going to be placed during the bonding process that is going to be described in the following. Prior to the initial state of the bonding system 700, the first surface 103 of the temperature probe 102 was moved into the field of view of the image capturing device 701, which captured a reference shape of the pattern 105 of the first surface 103. The reference shape of the pattern 105 of the first surface 103 was captured, before the first surface 103 of the temperature probe 102 was exposed to a heat source, thereby undergoing a change of temperature. The captured reference shape of the pattern 105 is going to be used in the following to determine a temperature profile according to a change of the shape of the pattern 105, after the pattern 105 was exposed to a temperature of the surface 104 of the substrate 101. The temperature is for example applied to the substrate 101 by means of the laser 703 from the opposite side of the surface 104 of the substrate 101.

FIG. 7B shows a second step of the operating example of the bonding system 700, in which the laser 703 is in a heating state, heating the opposite side of the surface 104 of the substrate 101 by means of a laser beam which is pointed towards the substrate 101, at the opposite side of the predefined position 402 on which the semiconductor device 704 is going to be placed. At the same time, the temperature probe 102 of the bonding device 100 is in a temperature measuring state. That is, the first surface 103 with the pattern 105 is pressed towards the surface 104 of the substrate 101 in order to establish contact between the first surface 103 and the surface 104 of the substrate 101. The temperature measuring state can either be established by the bonding device 100 by being arranged in a predefined position (i.e. by means of the bonding device 100 being pressed towards the surface 104 of the substrate 101), or by means of the single axis actuator 404, which presses the temperature probe 102 towards the surface 104 of the substrate 101. After the substrate 101 was heated by the laser 703, and the first surface 103 of the temperature probe 102 was exposed to the heated surface 104 of the substrate 101, the operating example of the bonding system 700 enters step 3.

FIG. 7C shows step 3 of the operating example of the bonding system 700. In step 3, the first surface 103 of the temperature probe 102 is removed from the surface 104 of the substrate 101, and is moved into the field of view of the image capturing device 701. Subsequently, the control unit 702 controls the image capturing device 701 to capture a current shape of the pattern 105. Typically, the movement of the first surface 103 from its position in the temperature measuring state in step 2 to the position in which the current shape of the pattern 105 of the first surface 103 is captured in step 3, and the capturing of the current shape of the pattern 105, have a duration of less than 2 seconds. The duration of the movement and the capturing (and the resulting heat dissipation at the first surface 103) is considered by the control unit 702 when evaluating the captured shape of the pattern 105 to determine the temperature profile. After determining a temperature profile by evaluating the captured shape of the pattern 105, it is decided by the control unit 702, whether the temperature of the predefined part 402 of the surface 104 of the substrate is suitable to proceed with bonding the semiconductor device 704 to the surface 104 of the substrate 101 in a next step. If the temperature is suitable, the operating example proceeds with step 4, which is described in view of FIG. 7D below. If the temperature is not suitable, step 2 is repeated. If the temperature of the predefined part 402 of the surface 104 of the substrate 101 is too high, a predefined amount of time can be waited and the substrate 101 can cool down, until temperature measurement is again performed as it is described in view of FIG. 7B, but without heating the substrate 101 by means of the laser 703. The first surface 103 with the pattern 105 afterwards can again be evaluated in step 3 as it is described in view of FIG. 7C.

FIG. 7D shows step 4 of the operating principle of the bonding system 700 in which the bonding system 700 is controlled by the control unit 702 according to the previously determined temperature profile. In particular, the bonding device 100 is controlled by the control unit 702 in order to place the semiconductor device 704 on the predefined part 402 of the surface 104 of the substrate 101.

It is to be noted that the semiconductor device 704 does not necessarily have to be held by the bonding tool 403 from the very beginning of the operating example, starting in step 1. It is also possible, that the semiconductor device 704 can be supplied to the bonding tool 403 before, during or after any other step of the operating principle. If the semiconductor device 704 is to be supplied to the bonding tool 403 between steps 2 and 3, the duration of this process is also considered in the control unit 702 when determining the temperature profile by evaluating the captured shape of the pattern 105.

The heated pattern 105 can be reset to the reference shape of the pattern 105 by cooling the pattern 105 to a default temperature before the next measurement. In a normal operating condition one measurement per batch operation (i.e. an operation in which a predefined amount of semiconductor devices 704 is bonded to the substrate 101) can be sufficient for optimized bonding.

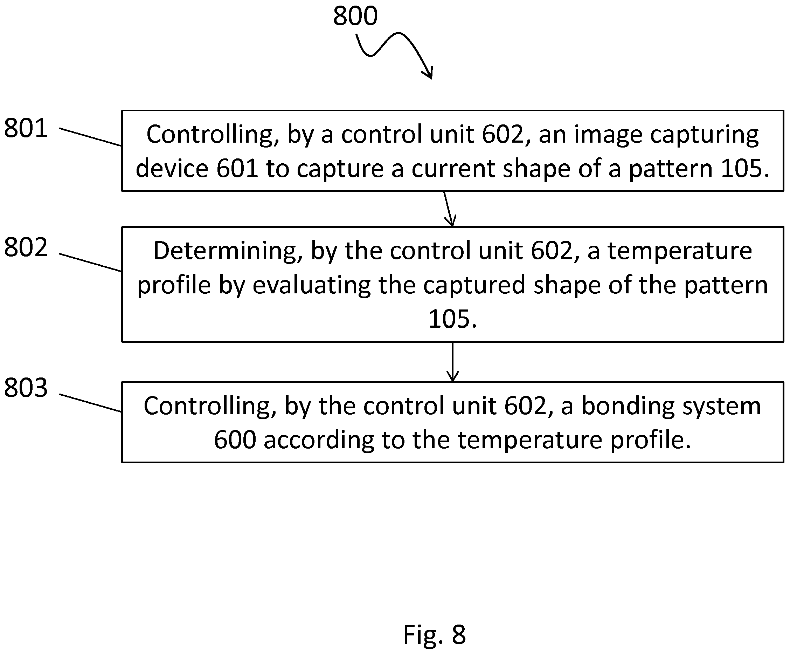

FIG. 8 shows a flow diagram of a method 800 for operating the bonding system 600 according to an embodiment of the present invention.

The method 800 comprises a first step of controlling 801, by a control unit 602, an image capturing device 601 to capture a current shape of a pattern 105.

Further, the method 800 comprises a second step of determining 802, by the control unit 602, a temperature profile by evaluating the captured shape of the pattern 105.

Further, the method 800 comprises a third step of controlling 803, by the control unit 602, a bonding system 600 according to the temperature profile.

The invention has been described in conjunction with various embodiments herein. However, other variations of the enclosed embodiments can be understood and effected by those skilled in the art and practicing the claimed invention, from a study of the drawings, the disclosure and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different independent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems.

## Claims

1. A bonding device (100) for bonding semiconductor devices to a substrate (101), the bonding device (100) comprising:
- a temperature probe (102) comprising a first surface (103), wherein
- the first surface (103) is configured to contact a surface (104) of the substrate (101) to measure a temperature of the surface (104) of the substrate (101), and
- the first surface (103) comprises a pattern (105) configured to change its shape according to the temperature of the surface (104) of the substrate (101),
wherein dimensions of the first surface (103) are larger than dimensions of a predefined part (402) of the surface (104) of the substrate (101), wherein the first surface (103) is configured to directly contact the predefined part (402) of the surface (104) of the substrate (101) to measure a temperature of the predefined part (402) of the surface (104) of the substrate (101),
wherein the predefined part (402) is a part of the surface (104) of the substrate (101), which is heated by a heating source,
wherein the pattern (105) comprised by the first surface (103) is a regular geometrical pattern.

2. The bonding device (100) according to claim 1, wherein the pattern (105) is formed in and/or on the first surface (103) by etching technology and/or anodization technology.

3. The bonding device (100) according to claim 1 or 2, wherein
the temperature probe (102) further comprises a main body (401) on which the first surface (103) is arranged.

4. The bonding device (100) according to claim 3, wherein
the main body (401) and the first surface (103) are formed of different materials.

5. The bonding device (100) according to claim 3 or 4, wherein
a thermal expansion coefficient of the material that is used to form the main body (401) is smaller than a thermal expansion coefficient of the material of which the first surface (103) is formed.

6. The bonding device (100) according to anyone of claims 1 to 5, wherein the bonding device (100) further comprises a bonding tool (403) and a single axis actuator (404), wherein the temperature probe (102) is arranged at the single axis actuator (404) of the bonding device (100), and wherein the single axis actuator (404) is configured to, in a temperature measuring state, press the temperature probe (102) towards the surface (104) of the substrate (101), such that the first surface (103) contacts the surface (104) of the substrate (101).

7. A bonding system (600) for bonding semiconductor devices to a substrate (101), the bonding system (600) comprising:
- the bonding device (100) according to anyone of claims 1 to 6,
- an image capturing device (601), and
- a control unit (602),
wherein the control unit (602) is configured to:
- control the image capturing device (601) to capture a current shape of the pattern (105),
- determine a temperature profile by evaluating the captured shape of the pattern (105), and
- control the bonding system (600) according to the temperature profile.

8. The bonding system (600) according to claim 7, wherein the control unit (602) is further configured to convert the captured shape of the pattern (105) into a spatial deformation profile of the first surface (103) by projecting the captured shape of the pattern (105) on a complete mathematical set of functions.

9. The bonding system (600) according to claim 8, wherein the control unit (602) is further configured to obtain the temperature profile from the spatial deformation profile, based on coefficients of the complete mathematical set of functions and a thermal expansion coefficient of the material of which the first surface (103) is formed.

10. A method (800) for operating the bonding system (600) according to anyone of claims 7 to 9, wherein the method (800) comprises:
- controlling (801), by the control unit (602), the image capturing device (601) to capture a current shape of the pattern (105),
- determining (802), by the control unit (602), a temperature profile by evaluating the captured shape of the pattern (105), and
- controlling (803), by the control unit (602), the bonding system (600) according to the temperature profile.

11. The method (800) according to claim 10, wherein the method (800) further comprises the step of converting, by the control unit (602), the captured shape of the pattern (105) to a spatial deformation profile of the first surface (103) by projecting the shape of the captured pattern (105) on a complete mathematical set of functions.

12. The method (800) according to claim 11, wherein the method (800) further comprises the step of obtaining, by the control unit (602), the temperature profile from the spatial deformation profile based on coefficients of the complete mathematical set of functions and a thermal expansion coefficient of the material of which the first surface (103) is formed.

## Patentansprüche

1. Bondvorrichtung (100) zum Bonden von Halbleitervorrichtungen an ein Substrat (101), wobei die Bondvorrichtung (100) Folgendes umfasst:
- eine Temperatursonde (102), die eine erste Fläche (103) umfasst, wobei
- die erste Fläche (103) dazu ausgelegt ist, eine Fläche (104) des Substrats (101) zu berühren, um eine Temperatur der Fläche (104) des Substrats (101) zu messen, und
- die erste Fläche (103) ein Muster (105) umfasst, das dazu ausgelegt ist, seine Form gemäß der Temperatur der Fläche (104) des Substrats (101) zu ändern,
wobei Abmessungen der ersten Fläche (103) größer sind als Abmessungen eines vordefinierten Teils (402) der Fläche (104) des Substrats (101), wobei die erste Fläche (103) dazu ausgelegt ist, den vordefinierten Teil (402) der Fläche (104) des Substrats (101) direkt zu berühren, um eine Temperatur des vordefinierten Teils (402) der Fläche (104) des Substrats (101) zu messen,
wobei der vordefinierte Teil (402) ein Teil der Fläche (104) des Substrats (101) ist, der von einer Heizquelle erwärmt wird,
wobei das Muster (105), das auf der ersten Fläche (103) umfasst ist, ein regelmäßiges geometrisches Muster ist.

2. Bondvorrichtung (100) nach Anspruch 1, wobei das Muster (105) in und/oder auf der ersten Fläche (103) mittels einer Ätztechnologie und/oder einer Anodisierungstechnologie gebildet ist.

3. Bondvorrichtung (100) nach Anspruch 1 oder 2, wobei
die Temperatursonde (102) ferner einen Hauptkörper (401) umfasst, auf dem die erste Fläche (103) angeordnet ist.

4. Bondvorrichtung (100) nach Anspruch 3, wobei
der Hauptkörper (401) und die erste Fläche (103) aus verschiedenen Materialien gebildet sind.

5. Bondvorrichtung (100) nach Anspruch 3 oder 4, wobei
ein Wärmeausdehnungskoeffizient des Materials, das verwendet wird, um den Hauptkörper (401) zu bilden, kleiner ist als ein Wärmeausdehnungskoeffizient des Materials, aus dem die erste Fläche (103) gebildet ist.

6. Bondvorrichtung (100) nach einem der Ansprüche 1 bis 5, wobei die Bondvorrichtung (100) ferner ein Bondwerkzeug (403) und einen Einachsenaktuator (404) umfasst, wobei die Temperatursonde (102) am Einachsenaktuator (404) der Bondvorrichtung (100) angeordnet ist und wobei der Einachsenaktuator (404) dazu ausgelegt ist, die Temperatursonde (102) in einem Temperaturmesszustand zur Fläche (104) des Substrats (101) zu drücken, derart, dass die erste Fläche (103) die Fläche (104) des Substrats (101) berührt.

7. Bondsystem (600) zum Bonden von Halbleitervorrichtungen an ein Substrat (101), wobei das Bondsystem (600) Folgendes umfasst:
- die Bondvorrichtung (100) nach einem der Ansprüche 1 bis 6,
- eine Bilderfassungsvorrichtung (601) und
- eine Steuereinheit (602),
wobei die Steuereinheit (602) zu Folgendem ausgelegt ist:
- Steuern der Bilderfassungsvorrichtung (601), um eine aktuelle Form des Musters (105) zu erfassen,
- Bestimmen eines Temperaturprofils durch Beurteilen der erfassten Form des Musters (105) und
- Steuern des Bondsystems (600) gemäß dem Temperaturprofil.

8. Bondsystem (600) nach Anspruch 7, wobei die Steuereinheit (602) ferner dazu ausgelegt ist, die erfasste Form des Musters (105) durch Projizieren der erfassten Form des Musters (105) auf einen vollständigen mathematischen Satz von Funktionen in ein Raumverformungsprofil der ersten Fläche (103) umzuwandeln.

9. Bondsystem (600) nach Anspruch 8, wobei die Steuereinheit (602) ferner dazu ausgelegt ist, auf Basis von Koeffizienten des vollständigen mathematischen Satzes von Funktionen und eines Wärmeausdehnungskoeffizienten des Materials, aus dem die erste Fläche (103) gebildet ist, das Temperaturprofil aus dem Raumverformungsprofil zu erhalten.

10. Verfahren (800) zum Betreiben des Bondsystems (600) nach einem der Ansprüche 7 bis 9, wobei das Verfahren (800) Folgendes umfasst:
- Steuern (801) der Bilderfassungsvorrichtung (601) durch die Steuereinheit (602), um eine aktuelle Form des Musters (105) zu erfassen,
- Bestimmen (802) eines Temperaturprofils durch Beurteilen der erfassten Form des Musters (105) durch die Steuereinheit (602) und
- Steuern (803) des Bondsystems (600) gemäß dem Temperaturprofil durch die Steuereinheit (602).

11. Verfahren (800) nach Anspruch 10, wobei das Verfahren (800) ferner den Schritt des Umwandelns der erfassten Form des Musters (105) durch Projizieren der Form des erfassten Musters (105) auf einen vollständigen mathematischen Satz von Funktionen in ein Raumverformungsprofil der ersten Fläche (103) durch die Steuereinheit (602) umfasst.

12. Verfahren (800) nach Anspruch 11, wobei das Verfahren (800) ferner den Schritt des Erhaltens des Temperaturprofils aus dem Raumverformungsprofil auf Basis von Koeffizienten des vollständigen mathematischen Satzes von Funktionen und eines Wärmeausdehnungskoeffizienten des Materials, aus dem die erste Fläche (103) gebildet ist, durch die Steuereinheit (602) umfasst.

## Revendications

1. Dispositif de collage (100) pour coller des dispositifs semi-conducteurs à un substrat (101), le dispositif de collage (100) comprenant :
- une sonde de température (102) comprenant une première surface (103),
- la première surface (103) étant configurée pour entrer en contact avec une surface (104) du substrat (101) pour mesurer une température de la surface (104) du substrat (101), et
- la première surface (103) comprenant un motif (105) configuré pour changer de forme en fonction de la température de la surface (104) du substrat (101),
les dimensions de la première surface (103) étant plus grandes que les dimensions d'une partie prédéfinie (402) de la surface (104) du substrat (101), la première surface (103) étant configurée pour entrer directement en contact avec la partie prédéfinie (402) de la surface (104) du substrat (101) pour mesurer une température de la partie prédéfinie (402) de la surface (104) du substrat (101),
la partie prédéfinie (402) étant une partie de la surface (104) du substrat (101), qui est chauffée par une source de chaleur,
le motif (105) compris par la première surface (103) étant un motif géométrique régulier.

2. Dispositif de collage (100) selon la revendication 1, le motif (105) étant formé dans et/ou sur la première surface (103) par une technologie de gravure et/ou une technologie d'anodisation.

3. Dispositif de collage (100) selon la revendication 1 ou 2, la sonde de température (102) comprenant en outre un corps principal (401) sur lequel la première surface (103) est agencée.

4. Dispositif de collage (100) selon la revendication 3,
le corps principal (401) et la première surface (103) étant formés de matériaux différents.

5. Dispositif de collage (100) selon la revendication 3 ou 4,
un coefficient de dilatation thermique du matériau qui est utilisé pour former le corps principal (401) étant inférieur à un coefficient de dilatation thermique du matériau dont la première surface (103) est formée.

6. Dispositif de collage (100) selon l'une quelconque des revendications 1 à 5, le dispositif de collage (100) comprenant en outre un outil de collage (403) et un actionneur à axe unique (404), la sonde de température (102) étant agencée au niveau de l'actionneur à axe unique (404) du dispositif de collage (100), et l'actionneur à axe unique (404) étant configuré pour, dans un état de mesure de la température, presser la sonde de température (102) vers la surface (104) du substrat (101), de telle sorte que la première surface (103) entre en contact avec la surface (104) du substrat (101).

7. Système de collage (600) pour coller des dispositifs à semi-conducteurs à un substrat (101), le système de collage (600) comprenant :
- le dispositif de collage (100) selon l'une quelconque des revendications 1 à 6,
- un dispositif de capture d'image (601), et
- une unité de commande (602),
l'unité de commande (602) étant configurée pour :
- commander le dispositif de capture d'image (601) pour capturer une forme actuelle du motif (105),
- déterminer un profil de température en évaluant la forme capturée du motif (105), et
- commander le système de collage (600) en fonction du profil de température.

8. Système de collage (600) selon la revendication 7, l'unité de commande (602) étant en outre configurée pour convertir la forme capturée du motif (105) en un profil de déformation spatiale de la première surface (103) en projetant la forme capturée du motif (105) sur un ensemble mathématique complet de fonctions.

9. Système de collage (600) selon la revendication 8, l'unité de commande (602) étant en outre configurée pour obtenir le profil de température à partir du profil de déformation spatiale, sur la base de coefficients de l'ensemble mathématique complet de fonctions et d'un coefficient de dilatation thermique du matériau dont la première surface (103) est formée.

10. Procédé (800) pour faire fonctionner le système de collage (600) selon l'une quelconque des revendications 7 à 9, le procédé (800) comprenant :
- la commande (801), par l'unité de commande (602), du dispositif de capture d'image (601) pour capturer une forme actuelle du motif (105),
- la détermination (802), par l'unité de commande (602), d'un profil de température en évaluant la forme capturée du motif (105), et
- la commande (803), par l'unité de commande (602), du système de collage (600) en fonction du profil de température.

11. Procédé (800) selon la revendication 10, le procédé (800) comprenant en outre l'étape de conversion, par l'unité de commande (602), de la forme capturée du motif (105) en un profil de déformation spatiale de la première surface (103) en projetant la forme du motif capturé (105) sur un ensemble mathématique complet de fonctions.

12. Procédé (800) selon la revendication 11, le procédé (800) comprenant en outre l'étape d'obtention, par l'unité de commande (602), du profil de température à partir du profil de déformation spatiale sur la base de coefficients de l'ensemble mathématique complet de fonctions et d'un coefficient de dilatation thermique du matériau dont la première surface (103) est formée.
